# EUROPEAN PATENT SPECIFICATION

(11) **EP 4 572 591 B1**
(45) Date of publication and mention of the grant of the patent: **04.11.2026**
(21) Application number: 25171876.3
(22) Date of filing: 24.01.2022
(51) Int. Cl.: H10B 61/00, H10B 63/00, H10B 63/10, H10N 70/00, H10N 70/20

(54) **SWITCHING CELL**
SCHALTZELLE
CELLULE DE COMMUTATION

(30) Priority: 27.01.2021 FR 2100747
(43) Date of publication of application: 18.06.2025
(62) Document number(s) of the earlier application(s) in accordance with Art. 76 EPC: 22152949.8 / 4 036 997
(73) Proprietor: STMicroelectronics S.r.l., 20864 Agrate Brianza (MB) (IT)
(72) Inventor: CAPPELLETTI, Paolo Giuseppe, 20030 Seveso (MI) (IT); REDAELLI, Andrea, 20133 Milano (IT)
(74) Representative: Cabinet Beaumont

(56) References cited:
- US-A1- 2017 117 328
- US-A1- 2017 243 922
- US-A1- 2020 098 825
- US-A1- 2020 411 754

## Description

### Technical field

The present disclosure relates generally to electronic devices and more precisely to integrated switching cells arranged in arrays. The present disclosure specifically concerns ovonic threshold switching (OTS) devices.

### Background art

Among the chalcogenide materials, two categories are currently studied for being used in electronic devices and more particularly in the manufacturing of switching devices and memories. In particular, a distinction is made between electron switching materials without memory effect (OTS materials) and phase change materials. Both materials can be used in thin film in the electronic integrated devices.

An OTS material toggles between an "on" and "off" state depending on the amount of voltage potential applied across the cell. The state of the ovonic threshold switch changes when a voltage through the ovonic threshold switch exceeds a threshold voltage. Once the threshold voltage is reached, the "on" state is triggered and the ovonic threshold switch is in a substantially conductive state. If the current or voltage potential drops below the threshold value, the ovonic threshold switch returns to the "off" state.

Phase-change materials are materials which can switch, under the effect of heat, between a crystalline phase and an amorphous phase. Since the electric resistance of an amorphous material is significantly greater than the electric resistance of a crystalline material, such a phenomenon may be useful to define two memory states, differentiated by the resistance measured through the phase-change material. The most common phase-change materials used in phase change memories are alloys made up of germanium, of antimony, and of tellurium.

Ovonic threshold switches would be useful as selecting devices thanks to their driving current capabilities in "on" state and current ratio between "on" and "off" states. However, ovonic Threshold Switches suffer of current overshoot at switching. Documents US2017/243922 A1, US2019/013357 A1, US2017/117328 A1 and US2020/098825 A1 disclose examples of electronic devices using OTS materials and/or phase change materials.

### Summary of Invention

There is a need for improvement of existing integrated switching cells containing an Ovonic Threshold Switch.

One embodiment aims at overcoming all or some of the drawbacks of existing switching cells in integrated devices.

The invention is defined by enclosed independent device claim 1.

According to an embodiment, the electronic cell comprises a memory layer between the first electrode and the ovonic threshold switch layer.

According to an embodiment, the electronic cell comprises a barrier layer between the memory layer and the ovonic threshold switch layer.

According to an embodiment, the memory layer is made of a phase change material.

According to an embodiment, the memory layer is a resistive random-access memory.

According to an embodiment, the memory layer is a magneto-resistive random-access memory.

According to an embodiment, the L-shaped cross-section of the resistor is self-aligned with the shape of the ovonic threshold switch layer.

One embodiment provides an array comprising several cells as described, wherein the cells are connected to word lines by their resistor and to bit lines by their first electrode.

### Brief description of drawings

The foregoing features and advantages, as well as others, will be described in detail in the following description of specific embodiments given by way of illustration and not limitation with reference to the accompanying drawings, in which:
Figure 1 illustrates two simplified cross-section views (A) and (B) of an embodiment of an Ovonic Threshold Switching cell;
Figure 2 illustrates two simplified cross-section views (A) and (B) of an Ovonic Threshold Switching cell not forming part of the invention;
Figure 3 illustrates a simplified cross-section view of an embodiment of a memory cell;
Figure 4 illustrates a simplified cross-section view of a memory cell not forming part of the invention;
Figure 5 illustrates a simplified schematic view of an array of memory cells;
Figure 6 illustrates, by schematic views, a step of a manufacturing process of the array of memory cells illustrated in Figure 5;
Figure 7 illustrates, by schematic views, another step of a manufacturing process of the array of memory cells illustrated in Figure 5;
Figure 8 illustrates, by schematic views, another step of a manufacturing process of the array of memory cells illustrated in Figure 5;
Figure 9 illustrates, by schematic views, another step of a manufacturing process of the array of memory cells illustrated in Figure 5; and
Figure 10 illustrates, by schematic views, another step of a manufacturing process of the array of memory cells illustrated in Figure 5.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, electric connections between switching cells organized in array, and selection circuits have not been detailed, the disclosed embodiments being compatible with existing switch arrays or memory array and the corresponding addressing circuitry.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

The disclosed embodiments aim at overcoming all or part of the drawbacks of the conventional Ovonic Threshold Switch regarding the voltage snap-back, which occurs after thresholding the OTS and which causes current overshoots. The disclosed therefore provide a resistive element, electrically in series with the OTS to absorb these overshoots. More particularly, the disclosed embodiments provide a solution, which allows the integration, with an OTS cell, of a series connected resistor without requiring additional surface area.

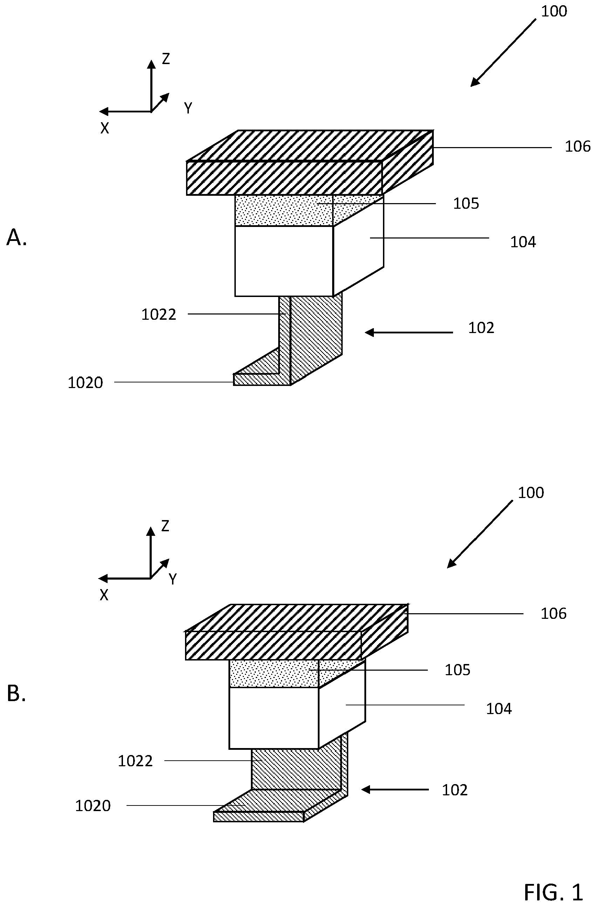

Figure 1 illustrates two simplified cross-section views (A) and (B) of an embodiment of an Ovonic Threshold Switching cell 100.

The representation of Figure 1 represents only one cell or OTS, but it should be noted that the switching cell of the present disclosure is part of a large number of integrated switching cells manufactured using thin film layers of chalcogenide materials, semi conductive materials, resistive materials, insulating materials, conductive materials, etc.

For sake of simplification, reference is made to layers to designate the corresponding elements of a stack forming the switching cell. It should however be understood that the corresponding layers correspond, in practice, to thin films deposited and etched to form individual switching elements separated by insulating trenches and arranged, for example in arrays. The terminals or electrodes of each switching cell may be interconnected, for example in lines and in columns, by corresponding layers of the stack.

A cell 100 comprises a resistor 102 or resistive element having a fixed resistance value, an ovonic threshold switch layer 104 or OTS layer, a top electrode 105 and a conductive layer 106, connected to the top electrode 105. The OTS layer 104 is located between the resistor 102 and the top electrode 105.

The OTS layer 104 has the property to have a significant decrease of resistivity when the voltage applied between the conductive layer 106 and the resistor 102 exceeds a threshold voltage VTH. This decrease (or increase) triggered by the voltage which is applied between the top and the bottom of the layer allows to consider the layer as forming a switch between an "off" state and an "on" state. If the voltage applied to OTS layer 104 is lower than the threshold VTH of the OTS layer 104, then the OTS layer 104 remains in the "off" or highly resistive state. In such a state, only a leakage current flows through the cell 100. If a voltage higher than the threshold VTH is applied, then the OTS layer 104 switches to the "on" state and operates in a relatively low resistive state. In the "on" state, a current flow through the cell 100. The threshold voltage VTH of the OTS layer 104 is, for example, inclusively between 0,5 V to 5 V.

The OTS layer 104 is, for example, made of a chalcogenide material, for example, chosen within the flowing list: germanium (Ge), tellurium (Te), selenium (Se), tungsten (W), antimony (Sb), arsenic (As), indium (In), sulfur (S) or any combination or alloy of these materials. The OTS layer 104 is made of a material the phase (crystallin) of which does not change upon the application of energy.

The OTS layer 104 has, for example, a thickness inclusively between 10 nm and 100 nm, preferably, between 20 nm and 40 nm.

Examples of ovonic materials adapted to form OTS layer 104 can be found in EP 2204851 A2.

The top electrode 105 typically forms an electrode (to be connected to the bit line) of the cell 100 while the resistor 102 forms another electrode (to be connected to the word line) of the cell 100.

The top electrode 105 is connected to the conductive layer 106. The conductive layers 106 form the bit lines. The top electrode 105 and the conductive layer 106 are, for example, in direct contact. The conductive layer 106 is, for example, connected to the top electrode 105 through a conductive via smaller than the top electrode 105 and made, for example, of tungsten.

The conductive layer 106 has, for example, the same width as, or a larger width than, one of the dimensions of the top electrode 105.

Each cell comprises one OTS layer 104 and one top electrode 105, which are separated from the OTS layers 104 and the top electrodes 105 of the adjacent cells by an insulating layer, not shown. Each OTS layer 104 is "fully confined", which means that the OTS layer 104 of each cell is separated from the OTS layers 104 of the adjacent cells by insulating material. The OTS layer 104 and the top electrode 105 have, for example, a parallelepipedal shape having, for example, for both layers the same width and the same length.

The resistor 102 has an L-shaped cross-section. The resistor 102 has then a horizontal portion 1020 and a vertical portion 1022. The resistor 102 is, for example, surrounded by an insulating layer, not shown. The thickness of this insulating layer is such that the upper surface of the vertical portion 1022 of the resistor 102 is coplanar with the upper surface of the insulating layer. The resistor 102 is in contact with the OTS layer 104.

The top electrode 105 and the resistor 102 are, for example, made of any refractory metal and/or refractory metal nitride, such as carbon (C), carbon nitride ((CN)n), titanium (Ti), titanium nitride (TiN), titanium silicon nitride (TiSiN), tungsten (W), tungsten nitride (W2 N, WN, WN2 ), tungsten carbon nitride, tungsten silicon nitride, tantalum (Ta), tantalum nitride (TaN), tantalum silicon nitride, tantalum tungsten, or any combination or alloy of these materials. The top electrode 105 and the resistor 102 are, for example, made of the same materials. The top electrode 105 and the resistor 102 are, for example, made of two different materials.

The top electrode 105 and the conductive layer 106 may be made of the same conductive material or of different conductive materials. The conductive layer 106 is, for example, made of copper.

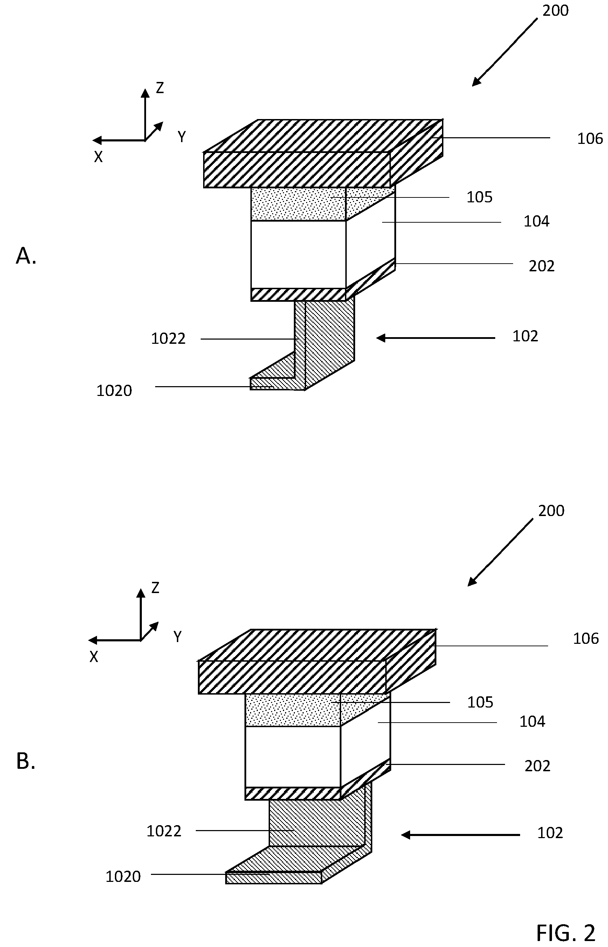

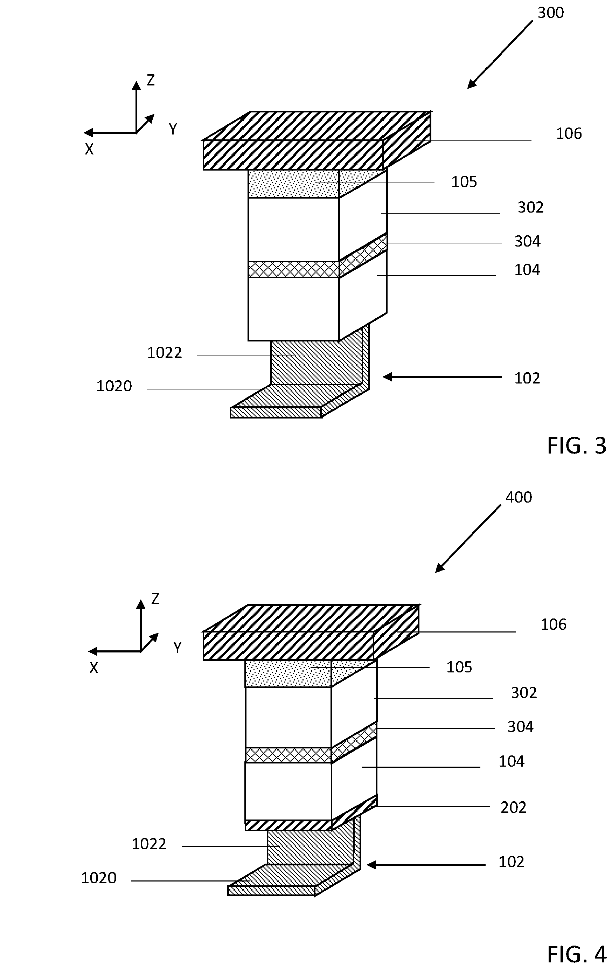

The embodiments of figures 1 and 3 as well as the examples of figures 2 and 4 are shown in space following an orthogonal spatial system XYZ in which the axis Z is orthogonal to the top face of the conductive layer 106 of the cell 100.

In the embodiment of view (A) and view (B), the top conductive layer 106 extends horizontally along the direction X. In the example of view (A), the vertical portion 1022 of the resistor 102 is preferably centered with respect to the cell 100 and extends vertically along the direction Y. In the example of view (B), the vertical portion 1022 of the resistor 102 is preferably centered with respect to the cell 100 and extends vertically along the direction X.

The difference between views (A) and (B) of figure 1 is therefore the orientation of the L-shaped resistor. View (A) is called a "self-aligned wall" cell architecture, in which the resistor 102 width is equal to the conductive layer 106 width. In view (A), the resistor 102 and the conductive layer 106 are, for example, formed using the same masking layer and in the same direction.

View (B) corresponds to a use of the "self-aligned wall technology" in a different way, in which the width of resistor 102 is not equal to the width of the conductive layer 106. In view (B), the resistor 102, the OTS layer 104 and the top electrode 105 are, for example, formed using the same masking layer as the one used to form the conductive layer 106 but oriented in the perpendicular direction compared to the direction of the conductive layer 106. The cell architecture of view (B) allows to integrate a resistor 102 into an OTS device with no area penalty at the cost of one not critical additional mask and few additional process steps.

In both view (A) and view (B), the interconnection (not shown) of the foots 1020 of the resistors 102 is perpendicular to the interconnection of the conductive layers 106. In other words, if the conductive layer 106 is organized in columns, the bottom electrode is organized in rows.

An advantage of the present embodiments is that the resistor 102 is not external to the cell 100 but is integrated to cell 100.

Figure 2 illustrates two simplified cross-section views (A) and (B) of an Ovonic Threshold Switching cell 200 not forming part of the invention.

The cell 200 illustrated in Figure 2 is similar to the cell 100 illustrated in Figure 1 with the difference that the cell 200 comprises a local bottom electrode 202. The bottom electrode 202 is, for example, located below the OTS layer 104, that means that the bottom electrode 202 is located between the resistor 102 and the OTS layer 104. The bottom electrode 202 extends, for example, below the entire surface of the OTS layer 104, that means that the bottom electrode 202 has the same length and the same width than the length and the width of the OTS layer 104. The resistor 102 is, for example, in contact with the bottom electrode 202 which is in contact with the OTS layer 104.

The local bottom electrode 202 provides a uniformization of the electrical current flow in all the surface of the OTS layer 104.

The bottom electrode 202 is, for example, made of any conductive material, such as carbon (C) or carbon nitride ((CN)n). The bottom electrode 202 is, for example, not made of a metal or a combination of metals.

The bottom electrode 202 has, for example, a thickness inclusively between 1 nm and 10 nm and preferably, between 4 nm and 6 nm.

In the example of view (A), the vertical portion 1022 of the resistor 102 is preferably centered with respect to the cell 200 and extends vertically along the direction Y.

In the example of view (B), the vertical portion 1022 of the resistor 102 is preferably centered with respect to the cell 200 and extends vertically along the direction X.

The provision of a resistor 102 integrated with an OTS cell offer new integration opportunities for various devices. In particular, this allows the integration of a switch with a memory cell at no cost of additional area.

Figure 3 illustrates a cross-section view of an embodiment of a memory cell 300.

Figure 4 illustrates a cross-section view of a memory cell 400 not forming part of the invention.

The memory cell 300 illustrated in Figure 3 and the memory cell 400 illustrated in Figure 4 are respectively similar to the cell 100 illustrated in the view (B) of Figure 1 and the cell 200 illustrated in the view (B) of Figure 2 with the difference that memory cells 300, 400 comprise a memory layer 302. The memory layer 302 is located above the OTS layer 104 and between the OTS layer 104 and the top electrode 105.

When the voltage applied to the cell is higher than a threshold voltage (VTH) of the OTS layer 104, an electrical current may flow through the OTS layer 104 and the memory layer 302 in the memory cell 300, 400 and may result in changing the resistivity of the layer 302. This change may alter the memory state of the layer 302, thus altering the electrical characteristic of the memory cell 300, 400.

The high resistive state may be associated with a "reset" state or a logic "0" value, while a low resistive state may be associated with a "set" state, or a logic "1" value.

According to the embodiment of Figures 3 and the example of figure 4, the memory cells 300, 400 comprise a barrier layer 304 between the memory layer 302 and the OTS layer 104.

The memory layer 302 may be made of a phase change material (PCM) that switches from a high resistance state, generally amorphous, to a low resistance state, generally crystalline, upon the application of energy such as heat, light, voltage potential, or electrical current. The phase change material may be switched from completely amorphous to completely crystalline or between different detectable states of local order across the entire spectrum between completely amorphous and completely crystalline. In the case that the memory layer 302 is a PCM layer, the resistor 102 is, for example, a heating compound. The memory layer 302 is, for example, made of any phase change materials such as phase change chalcogenides. For example, the memory layer 302 is made of germanium, antimony, tellurium, or any alloy of all or some of these compounds.

The memory layer 302 may also be a resistive random-access memory (RRAM) layer. The memory layer 302 is, for example, made of one or more dielectric material in which a conduction path is formed upon the application of a relatively high voltage. The memory layer 302 is, more precisely made of chalcogenides (such as the alloy Ge2 Sb2 Te5 or the alloy AgInSbTe), binary transition metal oxides (such as nickel oxide and titanium dioxide), perovskites (such as Sr(Zr)TiO3 and Pr0.7 Ca0.3 MnO3 ), solid-state electrolytes (such as germanium monosulfide, germanium selenide, silicon oxide, copper sulfide), organic charge-transfer complexes (such as CuTCNQ), organic donor-acceptor systems (such as Al AIDCN), and/or two dimensional insulating materials like hexagonal boron nitride.

The memory layer 302 may also be a magneto-resistive random-access memory (MRAM) layer, that means that the electric resistance of the layer 302 changes upon the application of an electron current. The memory layer 302 is formed from two ferromagnetic layers, each of which can hold a magnetization, separated by a thin insulating layer. One of the two ferromagnetic layers, called "fixed layer", has a fixed magnetization direction and acts as an electron spin polarizer. The other ferromagnetic layer, called "free layer", has a direction that can be flipped by a relatively high programming current. The magnetization direction of the free layer can be reversed by reversing the direction of the programming current.

The memory layer 302 extends, for example, on the entire surface of the OTS layer 104, that means that the memory layer 302 has the same length and the same width than the length and the width of the OTS layer 104. The memory layer 302 has, for example, a thickness inclusively between 10 nm and 100 nm, preferably, between 30 nm and 60 nm.

The barrier layer 304 is, for example, a layer that limits the diffusion of the memory layer 302 into the OTS layer 104 and vice versa. The barrier layer 304 is, for example, used to limit the mix of the material of the memory layer 302 and the material of the OTS layer 104.

The barrier layer 304 is, for example, made of any conductive material and/or diffusion material, such as carbon (C) and carbon nitride ((CN)n). The barrier layer 304 is, for example, not made of a metal because of the diffusion of metal material in the OTS layer 104.

The barrier layer 304 extends, for example, upper the entire surface of the OTS layer 104, that means that the barrier layer 304 has the same length and the same width than the length and the width of the OTS layer 104 and the memory layer 302. The barrier layer 304 has, for example, a thickness inclusively between 5 nm and 30 nm, preferably, between 15 nm and 25 nm.

In the embodiment of Figure 3, the vertical portion 1022 of the resistor 102 is preferably centered with respect to the memory cell 300 and extends vertically along the direction X. In another embodiment, the vertical portion 1022 of the resistor 102 is preferably centered with respect to the memory cell 300 and extends vertically along the direction Y.

In the example of Figure 4, the vertical portion 1022 of the resistor 102 is preferably centered with respect to the memory cell 400 and extends vertically along the direction X. In another example, the vertical portion 1022 of the resistor 102 is preferably centered with respect to the memory cell 400 and extends vertically along the direction Y.

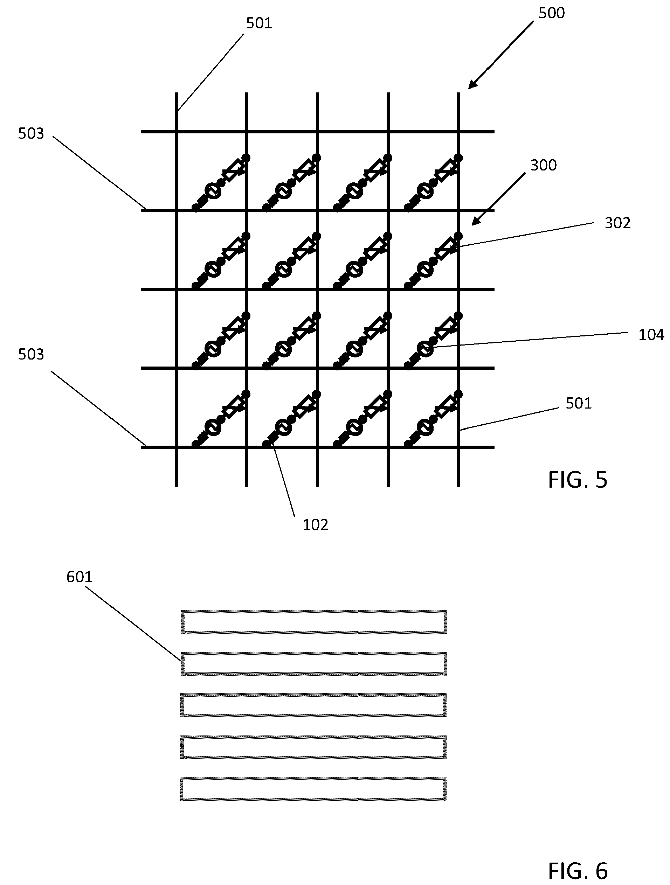

Figure 5 illustrates a simplified schematic view of an array of memory cells 500.

The array of memory cells 500 comprises a plurality of memory cells such as the memory cells 300 illustrated in Figure 3.

The memory cells 300 are, in Figure 5, positioned between a plurality of bit lines 501 and word lines 503. In Figure 5, bit lines 501 are illustrated with verticals lines and word lines 503 are illustrated with horizontal lines.

Each memory cell 300 includes the resistor 102, the OTS layer 104 (or OTS compound) and the memory layer 302 (or modular resistivity compound). According to an embodiment, each memory cell 300 is connected to a bit line 501 made of the conductive layer 106, by the top electrode 105 and is connected to a word line 503 by the resistor 102.

The array of memory cells 500 has been illustrated with memory cells 300, however, the array of memory cells 500 can be easily adapted to the cell 100, 200 or to the memory cell 400.

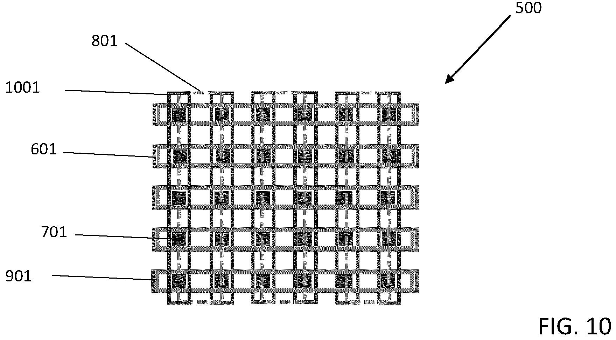

Figures 6 to 10 illustrate, by schematic views, steps of a manufacturing process of the array of memory cells 500 illustrated in Figure 5.

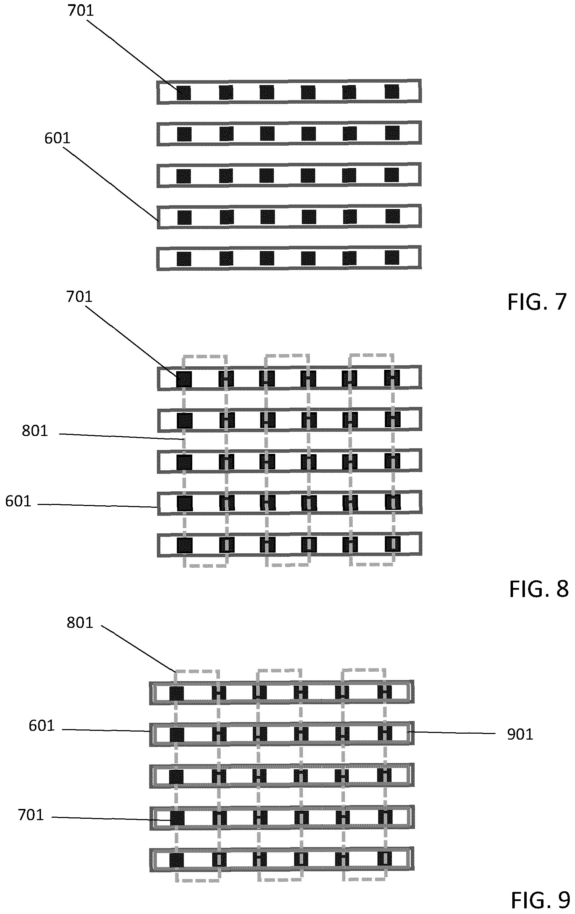

First, active areas are formed, using a mask 601 (Figure 6), for example, following a first direction, to create the word lines (503, Figure 5). Some contacts 701, are then formed on top of the active areas (Figure 7).

For example, resistors 102 are formed, through a mask 801 (Figure 8), for example, following a second direction, orthogonal to the first direction. After the formation of the resistor 102, the OTS layer 104 and the top electrode 105 are formed. The top electrode 105, the OTS layer 104 and the resistor 102 are then patterned using the "self-aligned wall" technology with the mask 901. After the deposition of an insulating layer and its removing with chemical mechanical polishing to expose the top electrode, the conductive layer 106 is deposited in order to form the bit lines (501, Figure 5).

For example, the conductive layer 106, the top electrode 105 and the OTS layer 104 are formed with the mask 1001. The conductive layer 106 forms the bit lines (501, Figure 5).

The masks are temporary masks, which are positioned for the concerned steps, and which are then removed as it is usual in microelectronic industry.

An advantage of including a resistor 102 in each cell of the array is that it permits to limit an overshoot of current which typically appears during threshold, and which disturbs the cell.

Another advantage of the present application is that it increases the lifetime of the cell.

Various embodiments and variants have been described. Those skilled in the art will understand that certain features of these embodiments can be combined, and other variants will readily occur to those skilled in the art.

Finally, the practical implementation of the embodiments and variants described herein is within the capabilities of those skilled in the art based on the functional description provided hereinabove.

## Claims

1. An electronic cell (100; 300) comprising an integrated stack having successively, vertically:
- a first electrode (105);
- an ovonic threshold switch layer (104); and
- a fixed resistor (102) connected to the ovonic threshold switch layer (104),
wherein the fixed resistor (102) has a L-shaped cross-section and has a horizontal portion (1020) and a vertical portion (1022),
**characterized in that** the fixed resistor (102) is in direct contact with the ovonic threshold switch layer (104), and wherein the vertical portion (1022) is located between the horizontal portion (1020) and the ovonic threshold switch layer (104).

2. The cell according to claim 1, wherein the fixed resistor (102) is surrounded by an insulating layer having a thickness such that an upper surface of the vertical portion (1022) of the fixed resistor (102) is coplanar with an upper surface of the insulating layer.

3. The cell according to claim 1 or 2, comprising a memory layer (302) between the first electrode (105) and the ovonic threshold switch layer (104).

4. The cell according to claim 3, comprising a barrier layer (304) between the memory layer (302) and the ovonic threshold switch layer (104).

5. The cell according to claim 3 or 4, wherein the memory layer (302) is made of a phase change material.

6. The cell according to claim 3 or 4, wherein the memory layer (302) is a resistive random-access memory layer.

7. The cell according to claim 3 or 4, wherein the memory layer (302) is a magneto-resistive random-access memory layer.

8. The cell according to any of claims 3 to 7, wherein the memory layer (302) extends above an entire surface of the ovonic threshold switch layer (104), and wherein the memory layer (302) has a thickness inclusively between 30 nm and 60 nm.

9. The cell according to any of claims 1 to 8, wherein the L-shaped cross-section of the resistor (102) is self-aligned with the shape of the ovonic threshold switch layer (104).

10. The cell according to any of claims 1-9, wherein the ovonic threshold switch layer (104) is made of a chalcogenide material chosen within the following list: germanium (Ge), tellurium (Te), selenium (Se), tungsten (W), antimony (Sb), arsenic (As), indium (In), sulfur (S) or any combination or alloy of these materials, and wherein the ovonic threshold switch layer (104) has a thickness inclusively between 20 nm and 40 nm.

11. The cell according to any of claims 1-10, wherein the vertical portion (1022) directly contacts, at a first end, the ovonic threshold switch layer (104), and, at a second opposite end, the horizontal portion (1020).

12. The cell according to anyone of claims 1-11, comprising a conductive layer (106) coupled to the first electrode (105), wherein the vertical portion (1022) of the fixed resistor (102) is centered with respect to the cell (100; 300) and extends vertically along a first direction, Y, perpendicular to the horizontal portion (1020), wherein a width of the fixed resistor (102) is equal to a respective width of the conductive layer (106).

13. The cell according to anyone of claims 1-11, comprising a conductive layer (106) coupled to the first electrode (105), wherein the vertical portion (1022) of the fixed resistor (102) is centered with respect to the cell (100) and extends vertically along a second direction, X, perpendicular to the horizontal portion (1020), wherein a width of the fixed resistor (102) is different from a respective width of the conductive layer (106).

14. The cell according to either claim 12 or 13, wherein the conductive layer (106) is in direct contact with the first electrode (105) through a conductive via smaller than the first electrode (105) and made of tungsten.

15. An array (500) comprising several cells (100; 300) according to any of claims 1 to 14, wherein, the cells are connected to word lines (503) by their fixed resistor (102) and to bit lines (501) by their first electrode (105).

## Patentansprüche

1. Eine elektronische Zelle (100; 300), die einen integrierten Stapel aufweist, der nacheinander vertikal Folgendes aufweist:
- eine erste Elektrode (105);
- eine ovonische Schwellenwert-Schaltschicht (104);
- einen Festwiderstand (102), der mit der ovonischen Schwellenwert-Schaltschicht (104) verbunden ist,
wobei der Festwiderstand (102) einen L-förmigen Querschnitt aufweist und einen horizontalen Abschnitt (1020) und einen vertikalen Abschnitt (1022) aufweist,
**dadurch gekennzeichnet, dass**
der Festwiderstand (102) in direktem Kontakt mit der ovonischen Schwellenwert-Schaltschicht (104) ist, und wobei der vertikale Abschnitt (1022) zwischen dem horizontalen Abschnitt (1020) und der ovonischen Schwellenwert-Schaltschicht (104) angeordnet ist.

2. Die Zelle gemäß Anspruch 1, wobei der Festwiderstand (102) von einer isolierenden Schicht umgeben ist, die eine Dicke hat, so dass einer obere Oberfläche des vertikalen Abschnitts (1022) des Festwiderstands (102) in einer gleichen Ebene wie eine obere Oberfläche der isolierenden Schicht ist.

3. Die Zelle gemäß Anspruch 1 oder 2, die eine Speicherschicht (302) zwischen der ersten Elektrode (105) und der ovonischen Schwellenwert-Schaltschicht (104) aufweist.

4. Die Zelle gemäß Anspruch 3, die eine Barrierenschicht (304) zwischen der Speicherschicht (302) und der ovonischen Schwellenwert-Schaltschicht (104) aufweist.

5. Die Zelle gemäß Anspruch 3 oder 4, wobei die Speicherschicht (302) aus einem Phasenwechselmaterial besteht.

6. Die Zelle gemäß Anspruch 3 oder 4, wobei die Speicherschicht (302) eine resistive Random-Access-Memory-Speicherschicht ist.

7. Die Zelle gemäß Anspruch 3 oder 4, wobei die Speicherschicht (302) eine magneto-resistive Random-Access-Memory-Speicherschicht ist.

8. Die Zelle gemäß einem der Ansprüche 3 bis 7, wobei sich die Speicherschicht (302) über eine gesamte Oberfläche der ovonischen Schwellenwert-Schaltschicht (104) erstreckt und wobei die Speicherschicht (302) eine Dicke zwischen einschließlich 30 nm und 60 nm aufweist.

9. Die Zelle gemäß einem der Ansprüche 1 bis 8, wobei der L-förmige Querschnitt des Widerstands (102) selbstausrichtend mit der Form der ovonischen Schwellenwert-Schaltschicht (104) ist.

10. Die Zelle gemäß einem der Ansprüche 1 bis 9, wobei die ovonische Schwellenwert-Schaltschicht (104) aus einem Chalkogenid-Material besteht, dass aus der folgenden Liste ausgewählt ist: Germanium (Ge), Tellur (Te), Selen (Se), Wolfram (W), Antimon (Sb), Arsen (As), Indium (In), Schwefel (S) oder einer beliebigen Kombination oder Legierung dieser Materialien, und wobei die ovonische Schwellenwert-Schaltschicht (104) eine Dicke zwischen einschließlich 20 nm und 40 nm aufweist.

11. Die Zelle gemäß einem der Ansprüche 1 bis 10, wobei der vertikale Abschnitt (1022) an einem ersten Ende direkt mit der ovonischen Schwellenwert-Schaltschicht (104) und an einem zweiten Ende direkt mit dem horizontalen Abschnitt (1020) in Kontakt steht.

12. Die Zelle gemäß einem der Ansprüche 1 bis 11, aufweisend eine leitfähige Schicht (106), die mit der ersten Elektrode (105) gekoppelt ist, wobei der vertikale Abschnitt (1022) des Festwiderstands (102) in Bezug auf die Zelle (100; 300) zentriert ist und sich vertikal entlang einer ersten Richtung, Y, senkrecht zum horizontalen Abschnitt (1020) erstreckt, wobei eine Breite des Festwiderstands (102) gleich einer jeweiligen Breite der leitfähigen Schicht (106) ist.

13. Die Zelle gemäß einem der Ansprüche 1 bis 11, aufweisend eine leitfähige Schicht (106), die mit der ersten Elektrode (105) gekoppelt ist, wobei der vertikale Abschnitt (1022) des Festwiderstands (102) in Bezug auf die Zelle (100) zentriert ist und sich vertikal entlang einer zweiten Richtung, X, senkrecht zum horizontalen Abschnitt (1020) erstreckt, und wobei eine Breite des Festwiderstands (102) von einer entsprechenden Breite der leitfähigen Schicht (106) verschieden ist.

14. Die Zelle gemäß Anspruch 12 oder 13, wobei die leitfähige Schicht (106) in direktem Kontakt mit der ersten Elektrode (105) über eine leitende Durchkontaktierung steht, die kleiner als die erste Elektrode (105) ist und die aus Wolfram besteht.

15. Ein Array (500), das mehrere Zellen (100; 300;) gemäß einem der Ansprüche 1 bis 14 aufweist, wobei die Zellen über ihren Festwiderstand (102) mit Wortleitungen (503) und über ihre erste Elektrode (105) mit Bitleitungen (501) verbunden sind.

## Revendications

1. Cellule électronique (100 ; 300) comprenant un empilement intégré ayant successivement, verticalement :
- une première électrode (105) ;
- une couche de commutateur à seuil ovonique (104) ; et
- une résistance fixe (102) connectée à la couche de commutateur à seuil ovonique (104) ,
dans laquelle la résistance fixe (102) a une section transversale en forme de L et a une portion horizontale (1020) et une portion verticale (1022),
**caractérisée en ce que** la résistance fixe (102) est en contact direct avec la couche de commutateur à seuil ovonique (104), et dans lequel la portion verticale (1022) est localisée entre la portion horizontale (1020) et la couche de commutateur à seuil ovonique (104).

2. Cellule selon la revendication 1, dans laquelle la résistance fixe (102) est entourée par une couche isolante ayant une épaisseur de sorte que la face supérieure de la portion verticale (1022) de la résistance fixe (102) soit coplanaire avec la face supérieure de la couche isolante.

3. Cellule selon la revendication 1 ou 2, comprenant une couche mémoire (302) entre la première électrode (105) et la couche de commutateur à seuil ovonique (104).

4. Cellule selon la revendication 3, comprenant une couche barrière (304) entre la couche mémoire (302) et la couche de commutateur à seuil ovonique (104).

5. Cellule selon la revendication 3 ou 4, dans laquelle la couche mémoire (302) est constituée d'un matériau à changement de phase.

6. Cellule selon la revendication 3 ou 4, dans laquelle la couche mémoire (302) est une couche mémoire à accès aléatoire résistive.

7. Cellule selon la revendication 3 ou 4, dans laquelle la couche mémoire (302) est une mémoire à accès aléatoire magnéto-résistive.

8. Cellule selon l'une quelconque des revendication 3 à 7, dans laquelle la couche mémoire (302) s'étend sur l'entièreté de la surface de la couche de commutateur à seuil ovonique (104), et dans laquelle la couche mémoire (302) a une épaisseur comprise entre 30 nm et 60 nm.

9. Cellule selon l'une quelconque des revendications 1 à 8, dans laquelle la section transversale en forme de L de la résistance (102) est auto-alignée avec la forme de la couche de commutateur à seuil ovonique (104).

10. Cellule selon l'une des revendications 1 à 9, dans laquelle la couche de commutation à seuil ovonique (104) est en un matériau chalcogénure choisi dans la liste suivante : germanium (Ge), tellure (Te), sélénium (Se), tungstène (W), antimoine (Sb), arsenic (As), indium (In), soufre (S) ou toute combinaison ou alliage de ces matériaux, et dans laquelle la couche de commutation à seuil ovonique (104) a une épaisseur comprise entre 20 nm et 40 nm, bornes comprises.

11. Cellule selon l'une des revendications 1 à 10, dans laquelle la portion verticale (1022) est en contact direct, à une première extrémité, avec la couche de commutation à seuil ovonique (104) et, à une deuxième extrémité, avec la partie horizontale (1020).

12. Cellule selon l'une des revendications 1 à 11, comprenant une couche conductrice (106) couplée à la première électrode (105), dans laquelle la partie verticale (1022) de la résistance fixe (102) est centrée par rapport à la cellule (100 ; 300) et s'étend verticalement le long d'une première direction, Y, perpendiculaire à la partie horizontale (1020), dans laquelle une largeur de la résistance fixe (102) est égale à une largeur respective de la couche conductrice (106).

13. Cellule selon l'une des revendications 1 à 11, comprenant une couche conductrice (106) couplée à la première électrode (105), dans laquelle la partie verticale (1022) de la résistance fixe (102) est centrée par rapport à la cellule (100) et s'étend verticalement le long d'une deuxième direction, X, perpendiculaire à la partie horizontale (1020), dans laquelle une largeur de la résistance fixe (102) est différente d'une largeur respective de la couche conductrice (106).

14. Cellule selon la revendication 12 ou 13, dans laquelle la couche conductrice (106) est en contact direct avec la première électrode (105) par l'intermédiaire d'un via conducteur plus petit que la première électrode (105) et fait en tungstène.

15. Réseau (500) comprenant plusieurs cellules (100 ; 300) selon l'une des revendications 1 à 14, dans lequel les cellules sont connectées à des lignes de mots (503) par leur résistance fixe (102) et à des lignes de bits (501) par leur première électrode (105).
